# EUROPEAN PATENT APPLICATION

(11) **EP 4 657 501 A1**
(43) Date of publication of application: **03.12.2025**
(21) Application number: 24774921.1
(22) Date of filing: 19.03.2024
(51) Int. Cl.: H01L 21/301, B23K 26/53, B23K 26/0622

(54) **LASER PROCESSING METHOD, LASER PROCESSING DEVICE, AND LASER LIGHT SOURCE**

(30) Priority: 23.03.2023 JP 2023047206
(71) Applicant: Tokyo Seimitsu Co., Ltd., Hachioji-shi, Tokyo 192-8515 (JP)
(72) Inventor: UEKIHARA Akira, Hachioji-shi, Tokyo 192-8515 (JP); OHMURA Etsuji, Suita-shi, Osaka 565-0871 (JP)
(74) Representative: Gill Jennings & Every LLP
(86) International application number: PCT/JP2024/010676
(87) International publication number: WO 2024/195786

(57) **Abstract**

In this laser processing method, a pulse waveform F of pulsed laser light L that forms a laser processing region P inside a workpiece (wafer W) includes a first stage waveform ST1 in which power of the pulsed laser light L rises to a maximum value (peak power Pmax) at time t0, a second stage waveform ST2 in which the power falls to a reference value (base power Pb) at time t1, and a third stage waveform ST3 in which the power is maintained within a predetermined fluctuation range without falling below the reference value, in which the reference value is within a range of 30% to 60% of the maximum value, the time t0 is within a range of 1% to 20% of the pulse width te, the time t1 is within a range of 3% to 40% of the pulse width te, and a time tp corresponding to half the maximum value is within a range of 2% to 40% of the pulse width te.

## Description

### TECHNICAL FIELD

The present invention relates to a laser processing method and laser processing device for forming a laser processing region inside a workpiece, and a laser light source used in the laser processing device. Priority is claimed on Japanese Patent Application No. 2023-047206 filed on March 23, 2023, the content of which is incorporated herein by reference.

### BACKGROUND ART

A silicon wafer (hereinafter simply referred to as "wafer") which is a workpiece has a plurality of devices partitioned into a grid pattern by streets (also referred to as processing lines or planned cutting lines) in a grid pattern, and individual devices are produced by dividing (cleaving) the wafer along the streets. As a pre-step of a dividing step in which the wafer is divided into a plurality of devices (chips), laser processing of the wafer is performed by a laser processing device.

For example, the laser processing device described in Patent Document 1 performs, as laser processing, internal focusing processing in which pulsed laser light is irradiated from a laser engine along the street while a focal position of an objective lens of the laser engine is aligned with the inside of the wafer, thereby forming a laser processing region that serves as a starting point for cutting inside the wafer along the street. Thereby, a fracture (also referred to as a crack) extends in a thickness direction of the wafer from the laser processing region, and the wafer is cleaved into individual devices in the dividing step.

Here, a typical pulse waveform (also referred to as a pulse shape) of pulsed laser light is chevron-shaped or trapezoidal, but in the laser processing device described in Patent Document 1, the pulse waveform is optimized to increase a dividing force when dividing the wafer in the dividing step. The dividing force referred to herein means ease with which a crack can extend.

### Citation List

### Patent Document

Patent Document 1: Japanese Unexamined Patent Application, First Publication No. 2011-251314

### SUMMARY OF INVENTION

### Technical Problem

When pulsed laser light is focused inside a wafer in internal focusing processing, a void is formed inside the wafer, and a laser processing region is formed from above the void toward an incident direction of the pulsed laser light. At this time, an energy required for forming the void and an energy required for forming the laser processing region are required in different sequences, and furthermore, amounts of energy required are also different. For this reason, when internal focusing processing is performed using pulsed laser light with a typical chevron-shaped pulse waveform, excessive energy that does not contribute to formation of the void and laser processing region is generated. As a result, there is a likelihood that the excessive energy may hinder formation of the laser processing region, or in a case in which the pulsed laser light is incident from a back surface of the wafer, the excessive energy may cause thermal damage to an electrode layer formed on a front surface of the wafer without being used in the internal focusing processing, or may cause thermal damage to the back surface of the wafer. Further, if the energy (power) of the pulsed laser light increases, there is a likelihood that a service life of the laser engine will be shortened. Further, the inventors have confirmed that, by bringing two wafers into close contact, the void and the laser processing region can be formed in different wafers, respectively. This is thought to suggest that the void is not essential for formation of the laser processing region.

In the laser processing device described in Patent Document 1 described above, the pulse waveform is optimized to increase the dividing force described above, but the above-described excessive energy generated in the internal focusing processing is not taken into consideration at all. Therefore, even in the laser processing device described in Patent Document 1, there is a likelihood that, due to the excessive energy, formation of the laser processing region may be hindered, thermal damage may be caused to the electrode layer and the back surface of the wafer, or the service life of the laser engine may be shortened.

The present invention has been made in view of such circumstances, and an objective of the present invention is to provide a laser processing method, a laser processing device, and a laser light source that enable internal focusing processing at a low pulse energy while maintaining processing performance of the internal focusing processing.

### Solution to Problem

A laser processing method for achieving the objective of the present invention is a laser processing method for forming a laser processing region inside a workpiece along a street of the workpiece by irradiating the workpiece with pulsed laser light with a focal point aligned inside the workpiece, in which a pulse waveform of the pulsed laser light includes a first stage waveform in which a power of the pulsed laser light rises to a maximum value at time t0, a second stage waveform in which the power falls from the maximum value to a reference value lower than the maximum value at time t1 after the first stage waveform, and a third stage waveform in which the power is maintained within a predetermined fluctuation range with respect to the reference value without falling below the reference value after the second stage waveform, the reference value is within a range of 30% to 60% of the maximum value, the time t0 is within a range of 1% to 20% of a pulse width te of the pulse waveform, the time t1 is within a range of 3% to 40% of the pulse width te, and a time tp corresponding to a first half width, which corresponds to half of the maximum value in the pulse waveform, is within a range of 2% to 40% of the pulse width te.

According to the laser processing method, it is possible to form the laser processing region inside the workpiece in the same manner as in the conventional case while reducing energy required for forming the laser processing region.

In the laser processing method according to another aspect of the present invention, one of half-value positions whose value is half of the maximum value in the pulse waveform may be included in the first stage waveform, and the other of the half-value positions may be included in the second stage waveform, and in the second stage waveform, a rate of decrease in the power from the maximum value to the other of the half-value positions may be greater than a rate of decrease in the power from the other of the half-value positions to the reference value.

In the laser processing method according to another aspect of the present invention, the power may be maintained constant at the reference value in the third stage waveform. Thereby, it is possible to form the laser processing region with a pulse waveform that is optimal for forming the laser processing region.

In the laser processing method according to another aspect of the present invention, the pulse width te may be a second half width corresponding to half of the reference value in the pulse waveform.

A laser processing device for achieving the objective of the present invention is a laser processing device for forming a laser processing region inside a workpiece along a street of the workpiece by irradiating the workpiece with pulsed laser light with a focal point aligned inside the workpiece, and the laser processing device includes a laser light source emitting the pulsed laser light, in which a pulse waveform of the pulsed laser light includes a first stage waveform in which a power of the pulsed laser light rises to a maximum value at time t0, a second stage waveform in which the power falls from the maximum value to a reference value lower than the maximum value at time t1 after the first stage waveform, and a third stage waveform in which the power is maintained within a predetermined fluctuation range with respect to the reference value without falling below the reference value after the second stage waveform, the reference value is within a range of 30% to 60% of the maximum value, the time t0 is within a range of 1% to 20% of a pulse width te of the pulse waveform, the time t1 is within a range of 3% to 40% of the pulse width te, and a time tp corresponding to a first half width, which corresponds to half of the maximum value in the pulse waveform, is within a range of 2% to 40% of the pulse width te.

A laser light source for achieving the objective of the present invention is a laser light source used for a laser processing device configured to form a laser processing region inside a workpiece along a street of the workpiece by irradiating the workpiece with pulsed laser light with a focal point aligned inside the workpiece, and emitting the pulsed laser light, in which a pulse waveform of the pulsed laser light includes a first stage waveform in which a power of the pulsed laser light rises to a maximum value at time t0, a second stage waveform in which the power falls from the maximum value to a reference value lower than the maximum value at time t1 after the first stage waveform, and a third stage waveform in which the power is maintained within a predetermined fluctuation range with respect to the reference value without falling below the reference value after the second stage waveform, the reference value is within a range of 30% to 60% of the maximum value, the time t0 is within a range of 1% to 20% of a pulse width te of the pulse waveform, the time t1 is within a range of 3% to 40% of the pulse width te, and a time tp corresponding to a first half width, which corresponds to half of the maximum value in the pulse waveform, is within a range of 2% to 40% of the pulse width te.

### Advantageous Effects of Invention

The present invention enables internal focusing processing at a low pulse energy while maintaining processing performance of the internal focusing processing.

### BRIEF DESCRIPTION OF DRAWINGS

[FIG. 1] A schematic diagram of a laser processing device.
[FIG. 2] A plan view of a wafer to be processed by the laser processing device.
[FIG. 3] A partial cross-sectional view of the wafer shown in FIG. 2.
[FIG. 4] A functional block diagram of a control device.
[FIG. 5] Reference sign 5A denotes an explanatory diagram for explaining a laser processing region formed inside the wafer during internal focusing processing, and reference sign 5B denotes an explanatory diagram showing a part of a back surface of the wafer after the internal focusing processing.
[FIG. 6] An explanatory diagram for explaining formation of a plurality of layers of the laser processing regions inside the wafer.
[FIG. 7] A graph showing an example of a pulse waveform showing a waveform for a single pulse of pulsed laser light.
[FIG. 8] An explanatory diagram for explaining a first evaluation test, showing the back surface of the wafer from a front surface side thereof.
[FIG. 9] Reference sign 9A is an explanatory view for explaining internal focusing processing of a comparative example, and reference sign 9B is an enlarged view of the back surface of the wafer after the internal focusing processing of the comparative example.
[FIG. 10] Reference sign XA is an explanatory view for explaining internal focusing processing of the present example, and reference sign XB is an enlarged view of the back surface of the wafer after the internal focusing processing of the present example.
[FIG. 11] A table showing a relationship between a power (W) of pulsed laser light L and presence or absence (OK/NG) of formation of a laser processing region P in the present example and the comparative example.
[FIG. 12] A cross-sectional view of the wafer after the internal focusing processing is performed with power of the pulsed laser light set to 0.4 W, 0.25 W, and 0.11 W in the present example and the comparative example.
[FIG. 13] A diagram showing a focusing position of the pulsed laser light in a simulation.
[FIG. 14] A diagram showing a standard pulse shape (pulse waveform) of the pulsed laser light L used in the simulation.
[FIG. 15] A graph showing an example of simulation results.
[FIG. 16] A diagram comparing pulse shapes (pulse waveforms) of two pulsed laser lights applied in the simulation.
[FIG. 17] A diagram showing a simulation analysis result using a conventional trapezoidal pulse shape.
[FIG. 18] A diagram showing a simulation analysis result using an optimal pulse shape.

### DESCRIPTION OF EMBODIMENTS

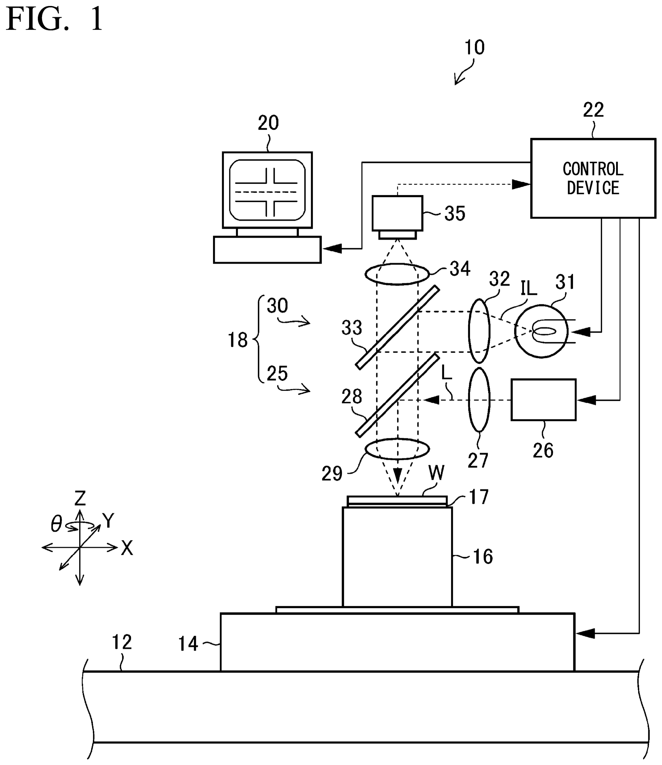

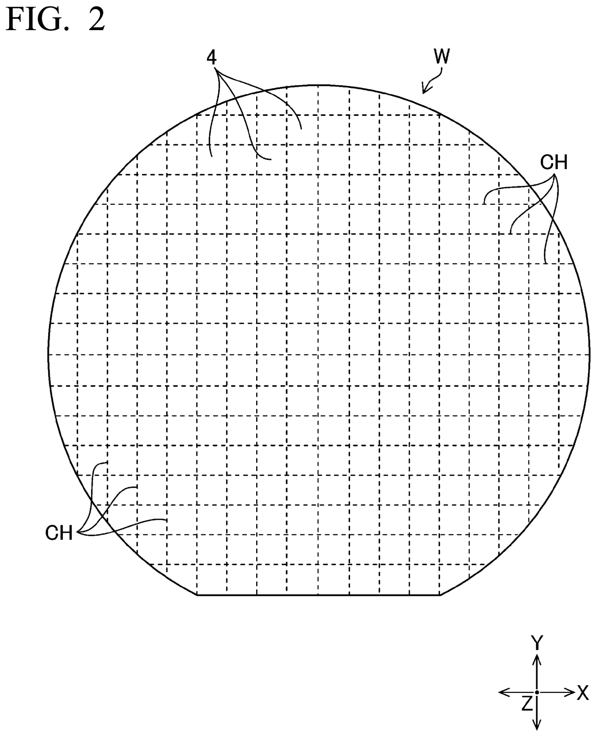

FIG. 1 is a schematic diagram of a laser processing device 10. As shown in FIG. 1, the laser processing device 10 performs internal focusing processing (laser processing) on a wafer W (for example, a silicon wafer), which corresponds to a workpiece of the present invention, as a pre-process of a dicing process for dividing the wafer W into a plurality of chips 4 (see FIG. 2). Further, the X, Y and Z directions in the drawing are orthogonal to each other, the X direction and the Y direction are in a horizontal direction, and the Z direction is in a vertical direction, in other words, a thickness direction of the wafer W. Also, a θ direction is a rotation direction with the Z direction as a rotation axis.

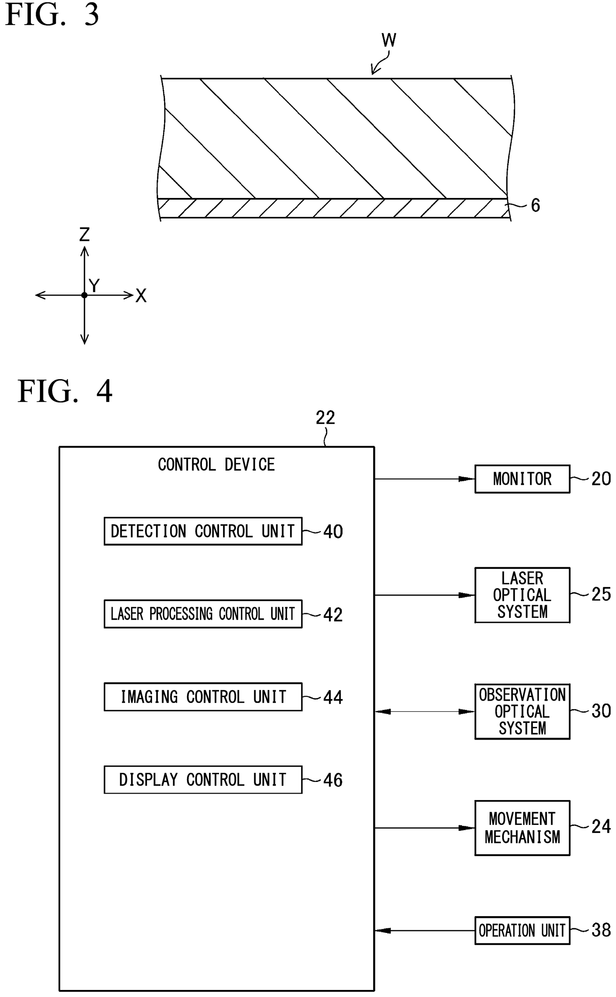

FIG. 2 is a plan view of the wafer W to be processed by the laser processing device 10. FIG. 3 is a partial cross-sectional view of the wafer W shown in FIG. 2. As shown in FIGS. 2 and 3, a plurality of streets CH are formed in a grid pattern on the wafer W. Thereby, the wafer W is partitioned into a plurality of regions by the respective streets CH. In each of the partitioned regions, a device layer 6 (electrode layer) constituting the chip 4 is provided.

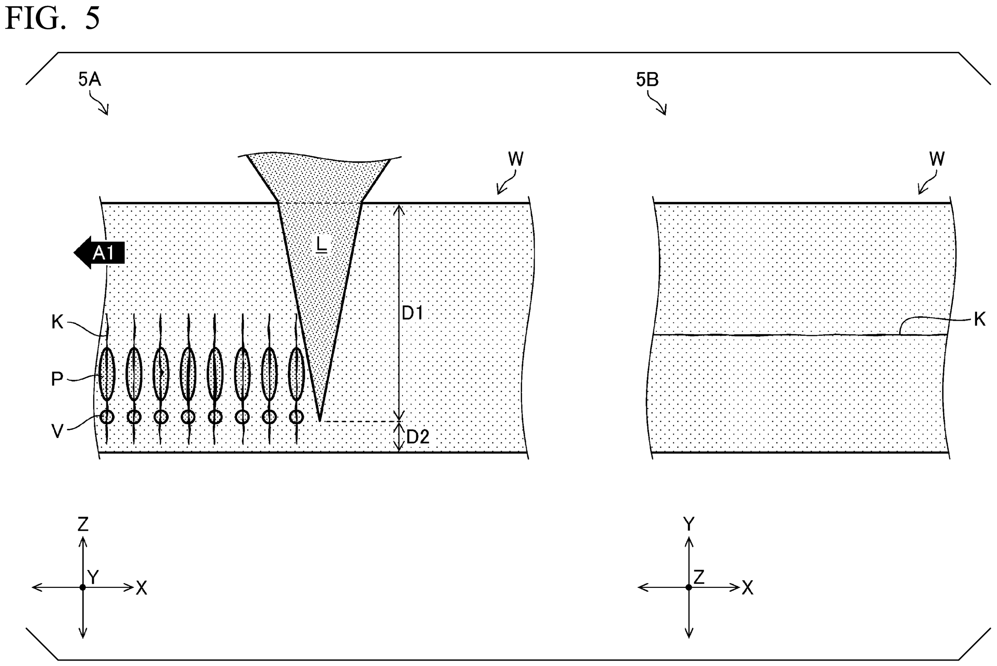

The laser processing device 10 forms a laser processing region P (see FIG. 5) inside the wafer W along each street CH by laser processing.

An XYZθ stage 14 is provided on a base 12. The XYZθ stage 14 is provided on the base 12 to be movable in the X, Y, and Z directions and rotatable in a θ direction. The XYZθ stage 14 is moved in the X, Y, and Z directions and rotated in the θ direction by a movement mechanism 24 (see FIG. 4) that is constituted by an actuator, a motor, and the like.

A suction stage 16 is provided on the XYZθ stage 14. The suction stage 16 holds, by suction, a surface of the wafer W on a side on which the device layer 6 is provided via a backgrind tape 17 or the like. Thereby, the wafer W is held by the XYZθ stage 14 so that a back surface on a side opposite to the surface faces a laser engine 18 to be described later. When the XYZθ stage 14 is caused to move in the X, Y, Z, and θ directions by the movement mechanism 24, the laser engine 18 is moved in the X, Y, Z, and θ directions relative to the wafer W on the suction stage 16.

The laser engine 18 includes a laser optical system 25 and an observation optical system 30. The laser engine 18 is disposed at a position facing the back surface of the wafer W above the suction stage 16 in the Z direction, and is controlled by a control device 22 to be described later.

The laser optical system 25 irradiates the back surface of the wafer W with pulsed laser light L. The laser optical system 25 includes a laser light source 26 (also referred to as a laser oscillator), a collimator lens 27, a half mirror 28, and a condenser lens 29.

The laser light source 26 emits the pulsed laser light **L,** which is for the internal focusing processing of the wafer W, toward the collimator lens 27. As conditions of the pulsed laser light L, for example, a light source is a semiconductor laser-excited Nd:YAG laser, a wavelength is 1.1 µm, a laser light spot cross-sectional area is 3.14×10⁻⁸cm², an oscillation mode is a Q-switched pulse, and a repetition frequency is 80 to 120 kHz. Further, a pulse width and power of the pulsed laser light L will be described later.

The collimator lens 27 converts the pulsed laser light L incident from the laser light source 26 into a parallel light beam, and then emits the pulsed laser light L toward the half mirror 28.

The half mirror 28 is disposed on an optical axis of the condenser lens 29 and reflects a part of the pulsed laser light L incident from the collimator lens 27 toward the condenser lens 29. Also, the half mirror 28 transmits a part of illumination light **IL,** which will be described later, incident from a half mirror 33, which will be described later, to the condenser lens 29, and transmits a part of reflected light of the illumination light **IL** incident from the condenser lens 29 to emit it toward the half mirror 33.

The condenser lens 29 focuses the pulsed laser light L and the illumination light **IL,** which are incident from the half mirror 28, onto the wafer W. Further, a focus of the condenser lens 29 is adjusted to a depth position during the internal focusing processing of the wafer W, and is adjusted to a position within the wafer W at which an arbitrary alignment reference is formed during alignment detection of the laser engine 18 with respect to the wafer W.

The observation optical system 30 is provided coaxially with the laser optical system 25 and captures an image of the alignment reference formed on the wafer W before the internal focusing processing of the wafer W. Also, the observation optical system 30 captures an image of a processing position during the internal focusing processing of the wafer W.

The observation optical system 30 shares the half mirror 28 and the condenser lens 29 with the laser optical system 25, and includes an illumination light source 31, a collimator lens 32, the half mirror 33, a condenser lens 34, an infrared camera 35, and the like.

The illumination light source 31 emits the illumination light **IL,** having a wavelength range that passes through the wafer W, toward the collimator lens 32. The illumination light **IL** is, for example, near-infrared light.

The collimator lens 32 converts the illumination light **IL** incident from the illumination light source 31 into a parallel light beam, and then emits the illumination light **IL** toward the half mirror 33.

The half mirror 33 is disposed on the optical axis of the condenser lens 29 and reflects a part of the illumination light **IL** incident from the collimator lens 32 toward the half mirror 28. Thereby, the illumination light **IL** is focused onto the back surface or inside of the wafer W via the half mirror 28 and the condenser lens 29. Also, the half mirror 33 transmits a part of the reflected light of the illumination light IL incident from the wafer W via the condenser lens 29 and the half mirror 28, and emits it toward the condenser lens 34.

The condenser lens 34 focuses the reflected light of the illumination light IL incident from the half mirror 33 onto the infrared camera 35.

The infrared camera 35 includes an imaging element (not shown) that is sensitive to a wavelength range of the illumination light IL, which is infrared light. Further, as the infrared camera 35, a camera having high sensitivity in the near-infrared region (wavelength region of 1 µm or more), such as an InGaAs (indium gallium arsenide) camera, is preferably used.

The infrared camera 35 captures an image of reflected light of the illumination light IL focused by the condenser lens 34 and outputs an observation image (captured image data) of the wafer W to the control device 22. An internal state of the wafer W can be confirmed on the basis of the observation image of the wafer W captured by the infrared camera 35 with the condenser lens 29 focused on the interior of the wafer W. Also, a state of the back surface or front surface of the wafer W can be confirmed on the basis of the observation image of the wafer W captured by the infrared camera 35 with the condenser lens 29 focused on the back surface or front surface of the wafer W.

A monitor 20 displays the observation image input from the infrared camera 35, various setting screens of the laser processing device 10, and the like.

The control device 22 comprehensively controls operations of various units of the laser processing device 10 such as the movement mechanism 24, the laser optical system 25, and the observation optical system 30, and performs alignment of the laser engine 18 and the internal focusing processing (laser processing) for each street CH.

FIG. 4 is a functional block diagram of the control device 22. As shown in FIG. 4, in addition to the monitor 20, the movement mechanism 24, the laser optical system 25, and the observation optical system 30 described above, the control device 22 is connected to an operation unit 38. Further, the operation unit 38 uses a known keyboard, a mouse, an operation button, or the like, and receives inputs of various operations by an operator.

The control device 22 is configured by an arithmetic device such as, for example, a personal computer, and includes an arithmetic circuit configured by various processors, memories, and the like. The various processors include a central processing unit (CPU), a graphics processing unit (GPU), an application specific integrated circuit (ASIC), and programmable logic devices such as, for example, simple programmable logic devices (SPLDs), complex programmable logic devices (CPLDs), and field programmable gate arrays (FPGAs). Further, various functions of the control device 22 may be realized by a single processor, or may be realized by a plurality of processors of the same type or different types.

The control device 22 functions as a detection control unit 40, a laser processing control unit 42, an imaging control unit 44, and a display control unit 46 by executing a control program (not shown). Hereinafter, what is described as a "unit" in the present embodiment may also be a "circuit," a "device," or "equipment". That is, what is described as a "unit" may be configured with firmware, software, hardware, or a combination of these.

The detection control unit 40 controls various units of the laser processing device 10 to perform alignment detection for detecting a position of each street CH of the wafer W held by the suction stage 16. The position of each street CH of the wafer W includes an orientation in an XY plane.

First, the detection control unit 40 controls the movement mechanism 24 and the observation optical system 30 to relatively move the infrared camera 35 to a position at which the alignment reference of the wafer W can be imaged. After this movement, the detection control unit 40 causes the infrared camera 35 to capture an image of the alignment reference. Thereby, an observation image of the alignment reference is acquired by the infrared camera 35, and the observation image is output from the infrared camera 35 to the detection control unit 40. Next, the detection control unit 40 detects the position of each street CH of the wafer W on the basis of the observation image of the alignment reference by detecting the alignment reference in the observation image using a known image recognition method.

The laser processing control unit 42 controls the movement mechanism 24 and the laser optical system 25 to perform the internal focusing processing for forming a laser processing region P (see FIG. 5) inside the wafer W along each street CH.

Specifically, the laser processing control unit 42 performs alignment to position the optical axis of the condenser lens 29 at one end of the first street CH by driving the movement mechanism 24 to adjust a position of the XYZθ stage 14 in the X, Y, and Z directions or to rotate it in the θ direction, on the basis of the alignment detection result by the detection control unit 40.

In FIG. 5, reference sign 5A is an explanatory diagram for explaining the laser processing region P formed inside the wafer W during the internal focusing processing, and reference sign 5B is an explanatory diagram showing a part of the back surface of the wafer W after the internal focusing processing.

As shown by reference sign 5A in FIG. 5, after the above-described alignment is completed, the laser processing control unit 42 controls the laser optical system 25 to adjust a focal point of the pulsed laser light L to a predetermined depth position D1 from the back surface of the wafer W, in other words, to a predetermined depth position D2 from the front surface of the wafer W. The depth position D1 is, for example, 380 µm, and the depth position D2 is, for example, 20 µm. Thereby, a void V is formed inside the wafer W at the depth position D1 from the back surface, in other words, at the depth position D2 from the front surface, and the laser processing region P is formed to extend from the void V toward an incident direction of the pulsed laser light L. As a result, a crack K extending in a thickness direction (Z direction) of the wafer W starting from the laser processing region P is generated.

Then, the laser processing control unit 42 drives the movement mechanism 24 to move the XYZθ stage 14 in the X direction (see arrow A1 in the drawing). Thereby, the laser optical system 25 is moved relative to the wafer W in the X direction while the pulsed laser light L is focused at the depth position D1. As a result, a plurality of laser processing regions P are formed inside the wafer W along the streets CH, and furthermore, the cracks K extending from the respective laser processing regions P reach the back surface of the wafer W as shown by reference sign 5B in FIG 5. Further, in reference sign 5B of FIG. 5, the crack K is shown in a simplified straight line to prevent the drawing from becoming complicated.

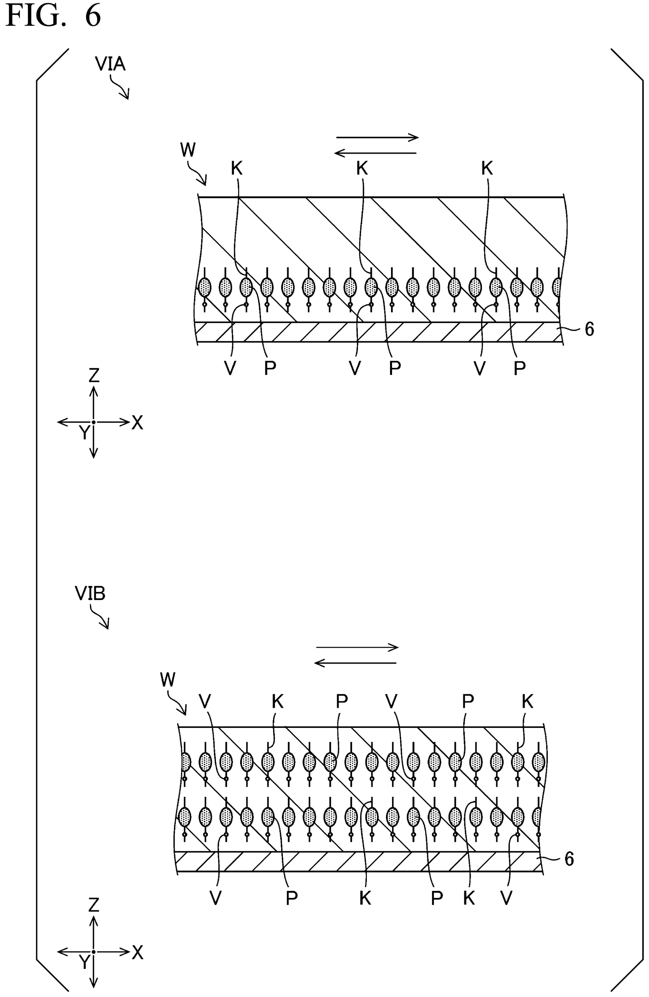

FIG. 6 is an explanatory diagram for explaining formation of a plurality of layers of the laser processing regions P inside the wafer W. As shown by reference signs VIA and VIB in FIG. 6, when the wafer W is thick, the laser processing control unit 42 forms a plurality of (two or more) layers of the laser processing regions P inside the wafer W along the street CH. Thereby, the crack K can reach the back surface of the wafer W even if the wafer W is thick.

Hereinafter, in the same manner, the laser processing control unit 42 forms one or more layers of the laser processing regions P inside the wafer W along all of the streets CH.

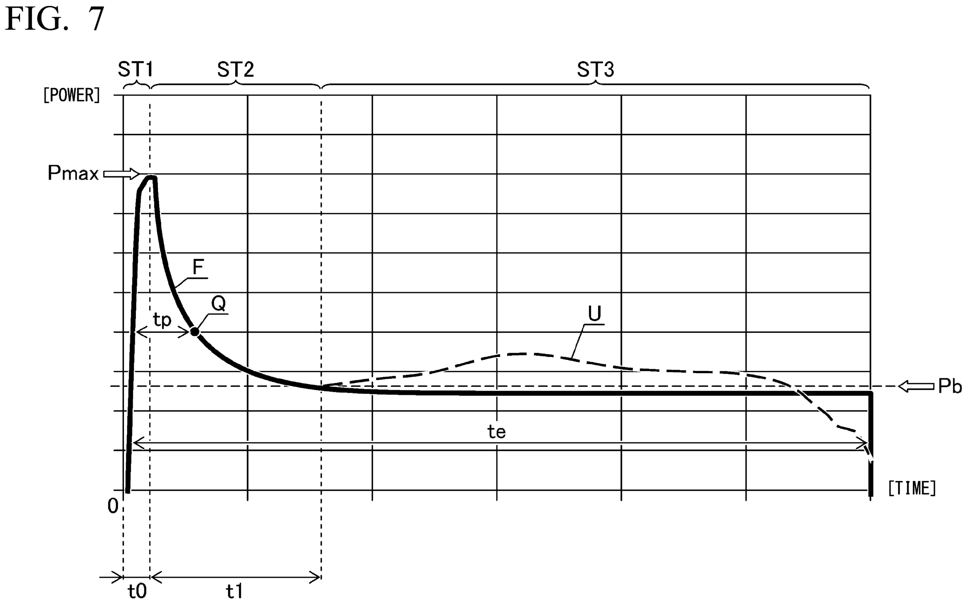

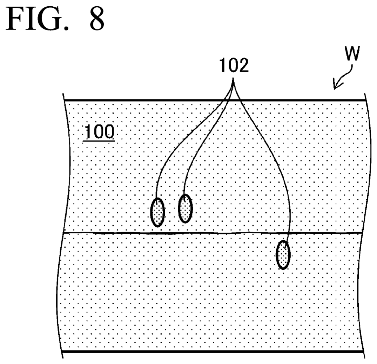

When such internal focusing processing is performed, if power (energy) of the pulsed laser light L is too high, excessive energy may hinder the formation of the laser processing region P or may cause a thermal damage 102 (see FIG. 8 ) on the device layer 6 and the back surface of the wafer W. Therefore, the laser processing device 10 of the present embodiment employs a laser processing method that optimizes a pulse waveform F (see FIG. 7) of the pulsed laser light L emitted from the laser light source 26, thereby enabling the internal focusing processing at a low pulse energy while maintaining processing performance of the internal focusing processing.

FIG. 7 is a graph showing an example of the pulse waveform F showing a waveform for a single pulse of the pulsed laser light L. Further, the horizontal axis of the graph represents time in units of nanoseconds (nsec), and the vertical axis represents power of the pulsed laser light L in units of Watts (W).

As shown in FIG. 7, the pulse waveform F includes waveforms of a total of three stages (also referred to as sections or regions): a first stage waveform ST1, a second stage waveform ST2, and a third stage waveform ST3. The first stage waveform ST1 and the second stage waveform ST2 are waveforms optimal for forming the void V and contribute to formation of the void V. Also, the third stage waveform ST3 is a waveform optimal for forming the laser processing region P and contributes to formation of the laser processing region P.

The first stage waveform ST1 is a waveform in which the power of the pulsed laser light L rises from an initial value to a peak power Pmax in time t0 (nsec). In FIG. 7, the initial value of the power of the pulsed laser light L is zero. The peak power Pmax corresponds to a maximum value in the present invention. Further, the initial value may be greater than zero. In the pulse waveform F, one of half-value positions (see time tp described below) whose value is half of the peak power Pmax is included in the first stage waveform ST1, and the other of the half-value positions (see reference sign Q) is included in the second stage waveform ST2 described below.

The second stage waveform ST2 is a waveform in which, after the first stage waveform ST1, the power of the pulsed laser light L falls from the peak power Pmax to a base power Pb that is lower than the peak power Pmax in a time t1 (nsec). The base power Pb corresponds to a reference value of the present invention.

Also, the second stage waveform ST2 includes the other half-value position (see reference sign Q) of the peak power Pmax as described above, and a rate of decrease in the power from the peak power Pmax to the other half-value position is greater than a rate of decrease in the power from the other half-value position to the base power Pb. That is, the rate of decrease in the power decreases at the other half-value position as a boundary.

The third stage waveform ST3 is a waveform in which, after the second stage waveform ST2, the power of the pulsed laser light L is maintained within a predetermined fluctuation range with respect to the base power Pb without falling below the base power Pb. For example, the third stage waveform ST3 is maintained constant at the base power Pb in an ideal shape indicated by the solid line, but fluctuates within the above-described fluctuation range in an actual shape indicated by the dotted line (see reference sign U). Further, the actual shape of the third stage waveform ST3 includes a falling section (fourth stage) in which the power falls below the base power Pb in a final stage. Further, the term "constant" described herein includes substantially constant.

The base power Pb is set to a value within a range of 30% to 60% of the peak power Pmax. Also, in a case in which a half width corresponding to half the base power Pb in the pulse waveform F is defined as a pulse width te (nsec), the time t0 is set to a length within a range of 1% to 20% of the pulse width te, and the time t1 is set to a length within a range of 3% to 40% of the pulse width te. Here, the pulse width te corresponds to a second half width of the present invention. Further, the pulse width te may be set to a length corresponding to one period (one pulse) of the pulsed laser light L.

Further, in the pulse waveform F, when a half width corresponding to half the peak power Pmax is defined as a first half width, a time tp corresponding to the first half width is set to a length within a range of 2% to 40% of the pulse width te.

For example, when the pulse width te is set to 300 nsec, the pulse waveform F shown in FIG. 7 satisfies time t0 = 10 nsec and time tp = 25 nsec. Also, the base power Pb of the pulse waveform F is set to 30% of Pmax.

In this way, in the pulse waveform F, the power of the pulsed laser light L steeply rises to the peak power Pmax in the first stage waveform ST1, steeply drops from the peak power Pmax in the second stage waveform ST2, and is then gently maintained at a constant value (including a substantially constant value) around the base power Pb without dropping excessively in the third stage waveform ST3. Thereby, an absorption rate of the pulsed laser light L is improved, particularly, in the third stage waveform ST3 by utilizing temperature dependence of the absorption rate of the pulsed laser light L by the wafer W. As a result, the energy (power of the pulsed laser light L) of the internal focusing processing which has been conventionally required to form the void V and the laser processing region P can be minimized.

As described above, in the present embodiment, when the pulsed laser light L having the pulse waveform F is used, even though the energy of the internal focusing processing is reduced, the void V and the laser processing region P are formed as in the conventional method, and furthermore an amount of extension of the crack K from the laser processing region P is prevented from decreasing compared to the conventional case. As a result, it becomes possible to perform the internal focusing processing with a low power of the pulsed laser light L while maintaining processing performance of the internal focusing processing. Furthermore, a lifespan of the laser engine 18 can be prolonged by reducing the power of the pulsed laser light L compared to the conventional case.

Hereinafter, a "first evaluation test" and a "second evaluation test" for verifying effects of the present embodiment will be described.

FIG. 8 is an explanatory diagram for explaining the first evaluation test, showing a back surface of the wafer W from a front surface side thereof. As shown in FIG. 8, in the first evaluation test, internal focusing processing was performed on the wafer W in both the "present example" and the "comparative example" with a low-melting-point metal thin film 100 provided on the back surface of the test wafer W, and the thermal damage 102 on the back surface of the wafer W was evaluated.

In the first evaluation test, a silicon wafer having a thickness of 400 µm, a length of 50 mm, and a width of 50 mm was used as the wafer W. Also, in the first evaluation test, the pulsed laser light L having a wavelength of 1085 nm and a frequency of 100 kHz was used. Also, a processing feed speed (a moving speed of the XYZθ stage 14 in the X direction) for the internal focusing processing in the first evaluation test was set to 800 mm/sec. Further, the internal focusing processing was performed under processing conditions in which the crack K reached the back surface of the wafer W when the depth position D1 was set to 380 µm. Further, when a wavelength of the pulsed laser light L is between 1000 nm and 1600 nm, results of the evaluation test exhibit the same tendency.

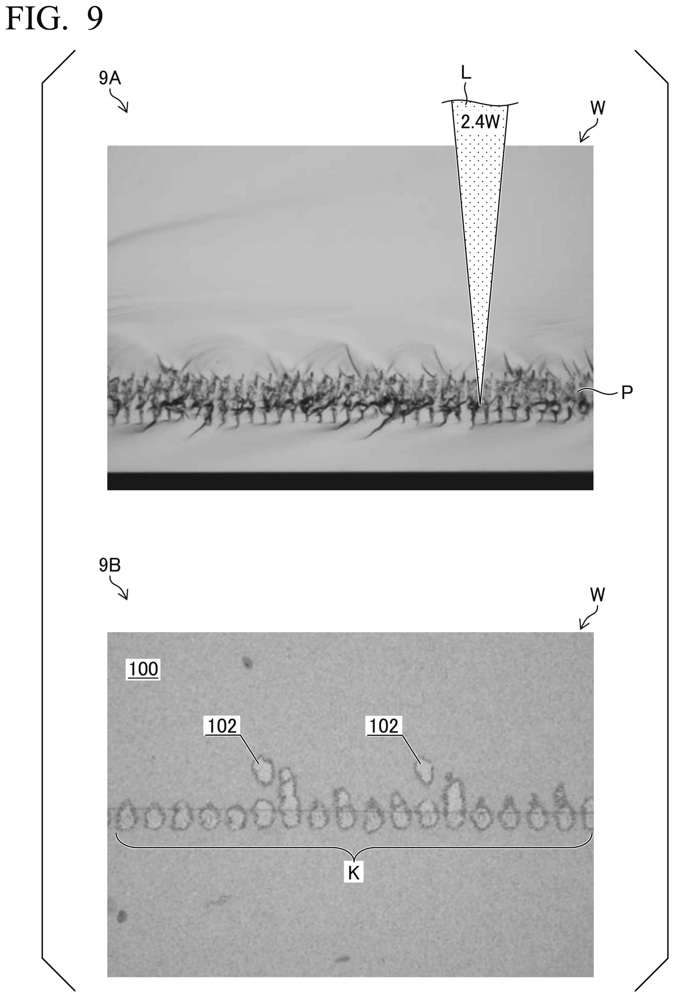

Reference sign 9A in FIG. 9 is an explanatory view for explaining internal focusing processing of the "comparative example," and reference sign 9B is an enlarged view of the back surface of the wafer W after the internal focusing processing of the "comparative example". As shown by reference sign 9A in FIG. 9, in the "comparative example," internal focusing processing was performed using the pulsed laser light L having a conventional chevron-shaped waveform. Also, in this case, the power of the pulsed laser light L was set to "2.4 W" as the processing condition in which the crack K reaches the back surface of the wafer W. Then, as shown by reference sign 9B in FIG. 9, imaging of the back surface (metal thin film 100) of the wafer W after the internal focusing processing of the "comparative example" was performed.

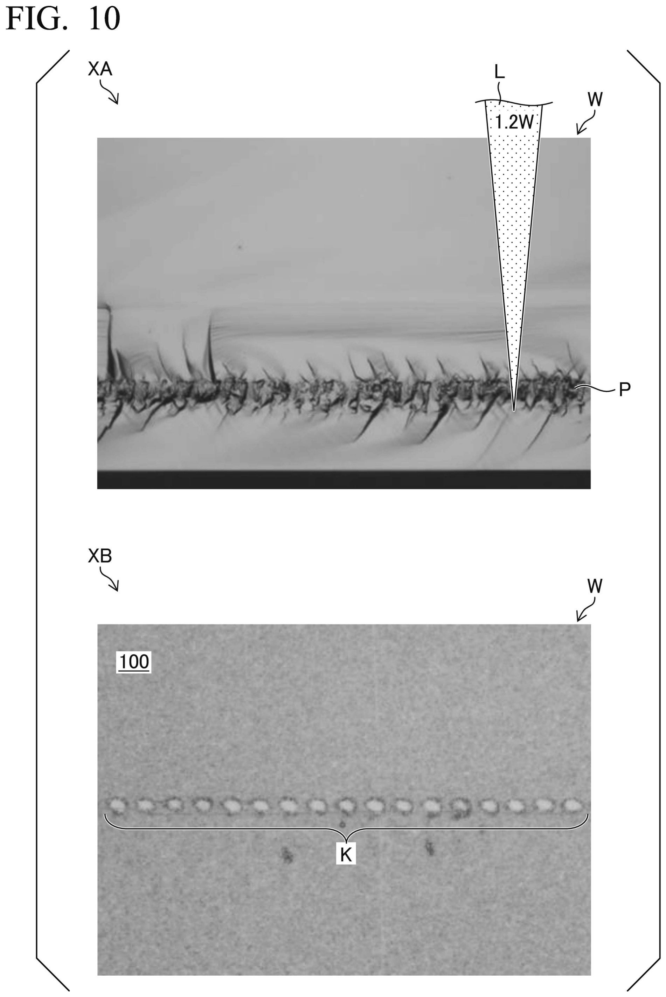

Reference sign XA in FIG. 10 is an explanatory view for explaining internal focusing processing of the "present example," and reference sign XB is an enlarged view of the back surface of the wafer W after the internal focusing processing of the "present example". As shown by the reference sign XA in FIG. 10, in the "present example," internal focusing processing was performed using the pulsed laser light L having the pulse waveform F. Also, in this case, since it was confirmed that the crack K reached the back surface of the wafer W at a power of 1.2 W which was lower than the power in the "comparative example," the power of the pulsed laser light L was set to "1.2 W" as the processing condition. Then, as shown by the reference sign XB in FIG. 10, imaging of the back surface (metal thin film 100) of the wafer W after the internal focusing processing of the "present example" was performed.

As a result of comparing the "present example" and the "comparative example," in the "present example," it was confirmed that the crack K reached the back surface of the wafer W even when the power was reduced from 2.4 W to 1.2 W under the same conditions as the "comparative example" except for the waveform and power of the pulsed laser light L. As a result, in the "present example," it was confirmed that the thermal damage 102 was reduced while maintaining the processing performance equivalent to that of the "comparative example".

**In** the second evaluation test, a limit value (minimum value) of the pulsed laser light L required for forming the void V and the laser processing region P when internal focusing processing was performed on the wafer W was evaluated in the "present example" and the "comparative example". **In** the second evaluation test, conditions other than the power of the pulsed laser light L were set to the same conditions as in the first evaluation test. Then, in the second evaluation test, internal focusing processing was performed while reducing the power of the pulsed laser light L in stages in the "present example" and the "comparative example", and presence or absence of formation of the laser processing region P including the void V was evaluated.

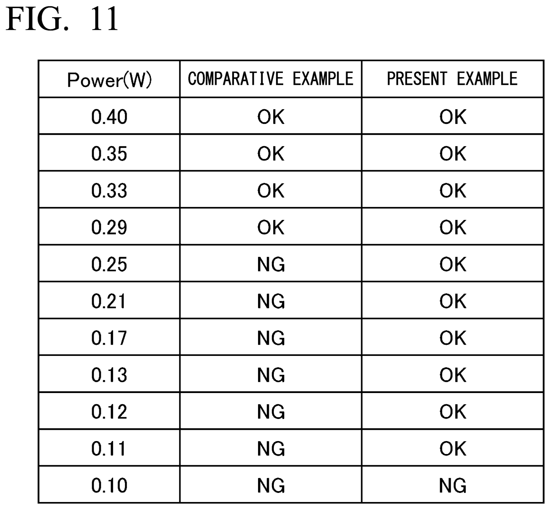

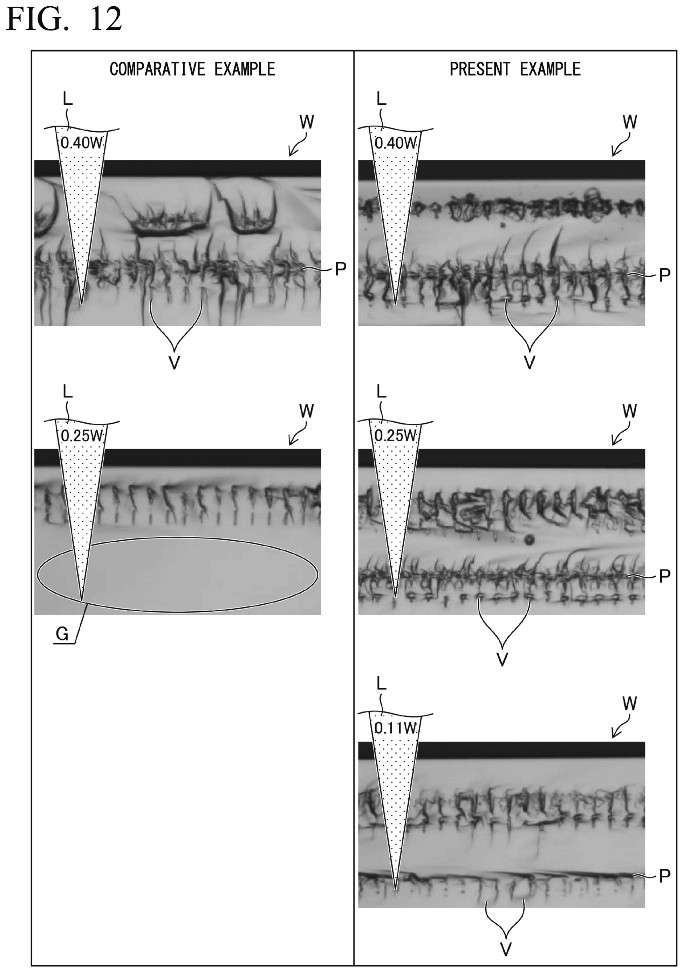

FIG. 11 is a table showing a relationship between the power (in units of W) of the pulsed laser light L and the presence or absence of formation of the laser processing region P in the "present example" and the "comparative example". In FIG. 11, a case in which the laser processing region P was formed was indicated as OK, and a case in which the laser processing region P was not formed was indicated as NG. FIG. 12 is a cross-sectional view of the wafer W after the internal focusing processing is performed with the power of the pulsed laser light L set to 0.4 W, 0.25 W, and 0.11 W in the "present example" and the "comparative example".

As shown in FIGS. 11 and 12, in the "comparative example," the limit value of the power of the pulsed laser light L required for formation of the laser processing region P was 0.29 W, and it was confirmed that, at a power of 0.25 W, the laser processing region P was not formed as shown in the region G corresponding to the depth position D1 in FIG. 12.

In contrast, in the "present example," it was confirmed that the limit value of the power of the pulsed laser light L could be reduced to 0.11 W. Thereby, in the "present example," since the power of the pulsed laser light L can be reduced compared to the conventional case, occurrence of the thermal damage 102 can be suppressed and a vertical width of the laser processing region P can be made smaller than that in the conventional case. When the vertical width of the laser processing region P is made small in this manner, finer internal focusing processing becomes possible.

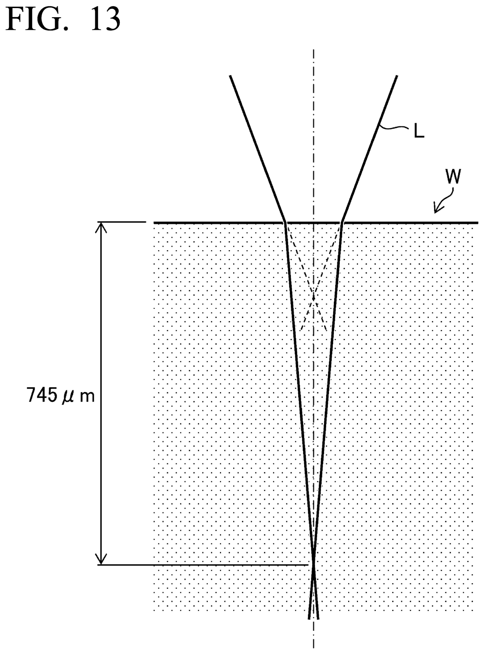

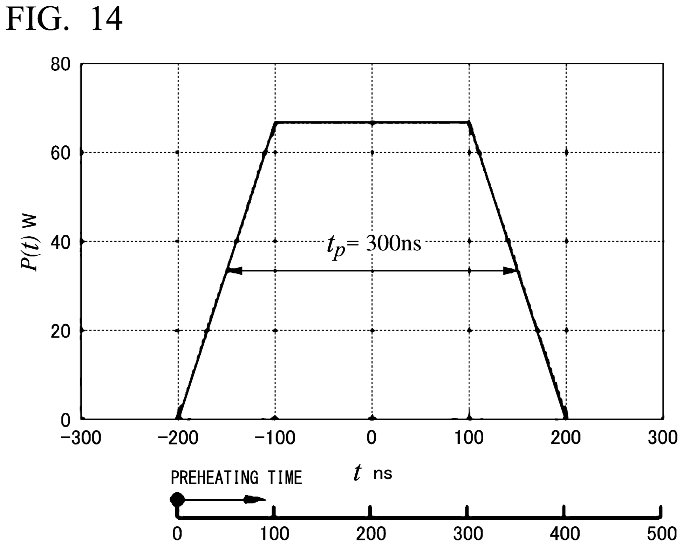

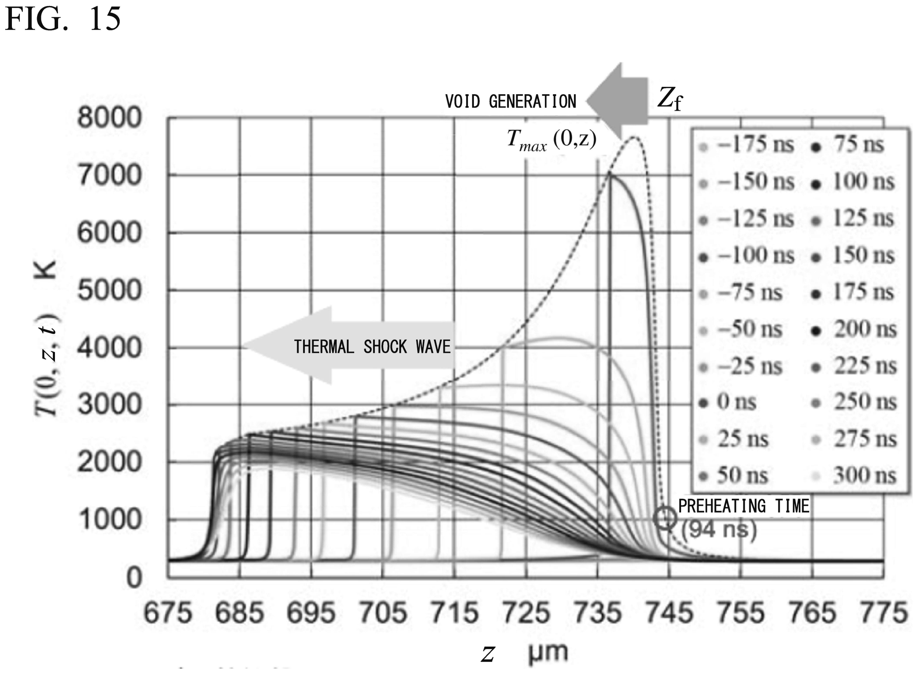

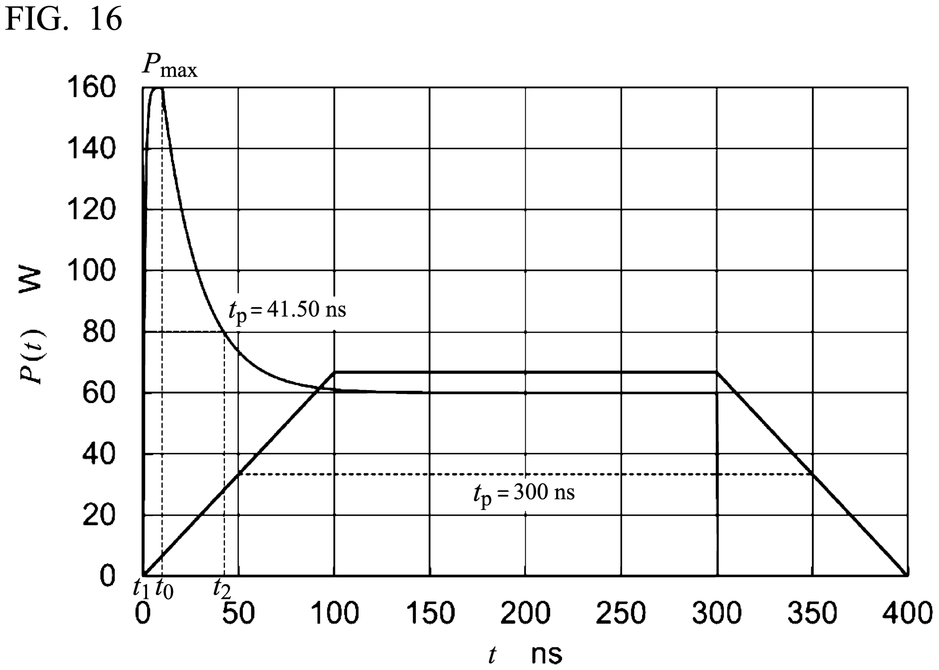

Next, effects of the present embodiment will be described more specifically. Further, FIG. 13 is a diagram showing a focusing position of the pulsed laser light L in a simulation. FIG. 14 is a diagram showing a standard pulse shape of the pulsed laser light L used in the simulation. FIG. 15 is a graph showing an example of simulation results. FIGS. 16 to 18 are diagrams for explaining results of simulation analyses performed using a conventional pulse shape and an optimal pulse shape of the present embodiment.

Pulse shape optimization in the pulsed laser processing inside the wafer W in the present embodiment is a result of a simulation based on thermal shock waves. The wafer W is a silicon (Si) wafer. Although it is known that single crystal silicon decreases in volume when it undergoes a phase change from solid to liquid, in the laser processing region P, dislocations in the single crystal are observed while amorphous silicon and polycrystalline silicon are not observed, and therefore, in the present simulation, the simulation is performed on the premise that melting does not occur. When the pulsed laser light L with the optimal pulse shape was prototyped based on the simulation results and then a processing evaluation was performed, it was confirmed that equivalent processing could be achieved with less energy compared to a trapezoidal pulse shape, and therefore effects of the simulation results could be actually confirmed.

The simulation results are shown below. As shown in FIG. 13, a time-dependent simulation analysis was performed for a Si thickness of 775 µm assuming that the pulsed laser light L is ideally focused at a depth of about 745 µm inside the Si from a laser incident surface side. The simulation is performed by adding a light propagation analysis to ray tracing and heat conduction analysis. In FIG. 14, a standard pulse shape of the pulsed laser light L is assumed to be trapezoidal with a center of the pulse shape set at t = 0. Also, a time from the start of the pulse to t = 0 is defined as a preheating time. A graph of an example of the simulation result (a temperature distribution on the optical axis) is shown in FIG. 15. The horizontal axis represents a depth z inside the Si in units of micrometers (µm), the vertical axis represents a temperature T in units of Kelvin (K), and the legend indicates an elapsed time in units of nanoseconds (ns). In the graph, the pulsed laser light L is incident from the left side, a void due to a rapid temperature rise is generated in the vicinity of a focal point of 745 µm, and then a thermal shock wave is generated in a laser incident direction (left side of the graph), but since the pulsed laser light L is absorbed at a distal end of the thermal shock wave, it can be confirmed that a temperature rise distribution changes over time as shown in the graph. It was found that the temperature reaches its peak at a preheating time of 94 ns (around t = -100 ns in the legend, because t = -106 ns) in the graph. In FIG. 15, it is shown that the temperature is highest at t = -100 ns in the legend.

Results of this simulation analysis performed using the conventional pulse shape and the optimal pulse shape of the present embodiment are shown in FIGS. 16 to 18. Further, the pulse energies of both were set to be the same.

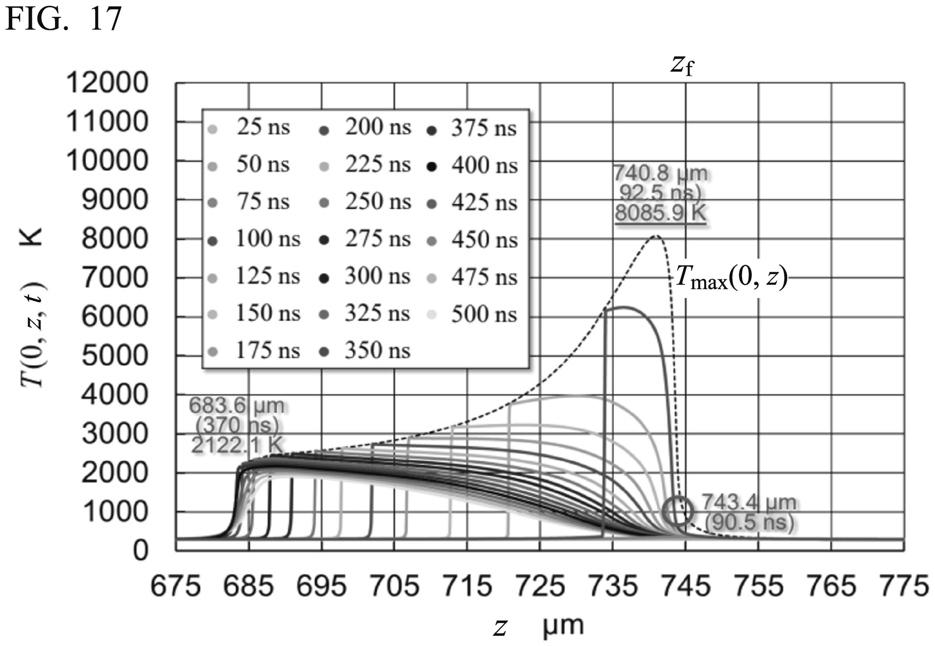

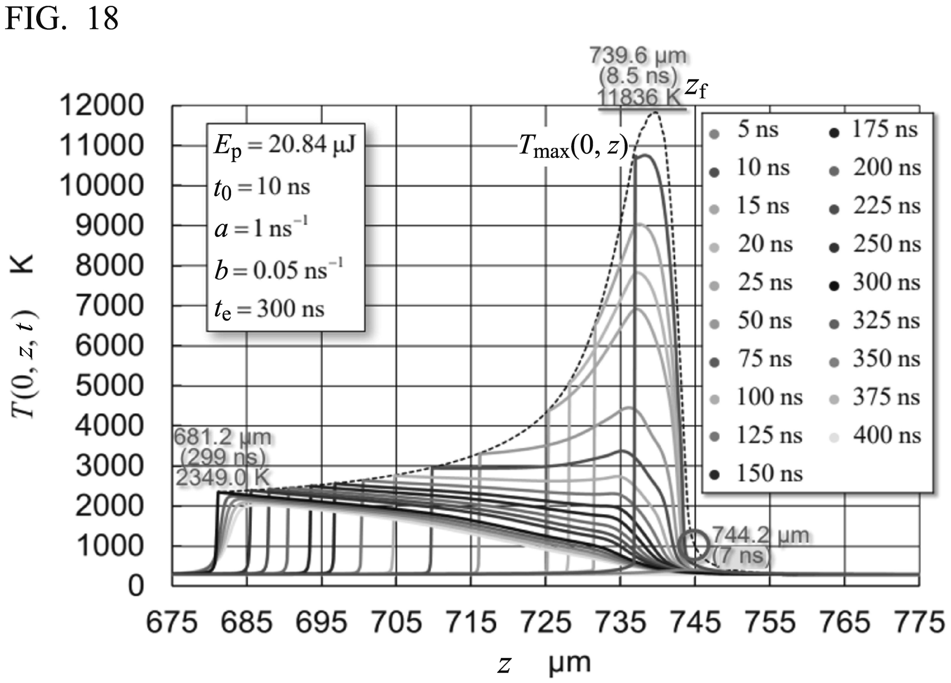

FIG. 16 is a diagram comparing pulse shapes of two pulsed laser lights L applied in the simulation. Further, areas thereof are the same to make the applied energy equivalent. FIG. 17 is a diagram showing simulation analysis results using the conventional trapezoidal pulse shape, and FIG. 18 is a diagram showing simulation analysis results using the optimal pulse shape.

Comparing the two results, first, the preheating time for reaching a maximum temperature was 90.5 ns for the trapezoidal pulse shape and 7 ns for the optimal pulse shape, and it is considered that voids are generated earlier as the preheating time becomes shorter, and the subsequent energy is used efficiently for formation of the laser processing region P. The maximum temperature reached is 11,836 K with the optimal pulse shape, which is higher than 8,085.9 K with the trapezoidal pulse shape. Also, regarding growth of the laser processing region P (a section from the void V to a position in which the temperature rises on the laser incident direction side is defined as the laser processing region P), the result is such that the growth length for the optimal pulse shape is 63 µm, which is longer than the growth length of 59.8 µm for the trapezoidal pulse shape.

### [Others]

In the above embodiment, the laser engine 18 is relatively moved with respect to the wafer W using the XYZθ stage 14 and the movement mechanism 24, but the configuration is not particularly limited as long as the laser engine 18 and the wafer W can be moved relative to each other.

**In** the above-described embodiment, an irradiation optical axis of the laser optical system 25 and an observation optical axis of the observation optical system 30 are coaxial, but the irradiation optical axis and the observation optical axis may be different from each other. That is, the laser optical system 25 and the observation optical system 30 may be provided separately.

**In** the above-described embodiment, the back side of the wafer W is irradiated with the pulsed laser light **L,** but the front side of the wafer W may be irradiated with the pulsed laser light L.

In the above-described embodiment, a silicon wafer has been described as an example of the workpiece of the present invention, but types of workpiece are not particularly limited.

### REFERENCE SIGNS LIST

4 Chip
6 Device layer
10 Laser processing device
12 Base
14 XYZθ stage
16 Suction stage
17 Backgrind tape
18 Laser engine
20 Monitor
22 Control device
24 Movement mechanism
25 Laser optical system
26 Laser light source
27 Collimator lens
28 Half mirror
29 Condenser lens
30 Observation optical system
31 Illumination light source
32 Collimator lens
33 Half mirror
34 Condenser lens
35 Infrared camera
38 Operation unit
40 Detection control unit
42 Laser processing control unit
44 Imaging control unit
46 Display control unit
100 Metal thin film
102 Thermal damage
CH Street
D1 Depth position
D2 Depth position
F Pulse waveform
IL Illumination light
K Crack
L Pulsed laser light
Nd Semiconductor laser-excited
P Laser processing region
Pb Base power
Pmax Peak power
ST1 First stage waveform
ST2 Second stage waveform
ST3 Third stage waveform
V Void
W Wafer
te Pulse width

## Claims

1. A laser processing method for forming a laser processing region inside a workpiece along a street of the workpiece by irradiating the workpiece with pulsed laser light with a focal point aligned inside the workpiece, wherein
a pulse waveform of the pulsed laser light includes:
a first stage waveform in which a power of the pulsed laser light rises to a maximum value at time t0;
a second stage waveform in which the power falls from the maximum value to a reference value lower than the maximum value at time t1 after the first stage waveform;
and
a third stage waveform in which the power is maintained within a predetermined fluctuation range with respect to the reference value without falling below the reference value after the second stage waveform,
the reference value is within a range of 30% to 60% of the maximum value,
the time t0 is within a range of 1% to 20% of a pulse width te of the pulse waveform,
the time t1 is within a range of 3% to 40% of the pulse width te, and
a time tp corresponding to a first half width, which corresponds to half of the maximum value in the pulse waveform, is within a range of 2% to 40% of the pulse width te.

2. The laser processing method according to claim 1, wherein
one of half-value positions whose value is half of the maximum value in the pulse waveform is included in the first stage waveform, and the other of the half-value positions is included in the second stage waveform, and
in the second stage waveform, a rate of decrease in the power from the maximum value to the other of the half-value positions is greater than a rate of decrease in the power from the other of the half-value positions to the reference value.

3. The laser processing method according to claim 1 or 2, wherein the power is maintained constant at the reference value in the third stage waveform.

4. The laser processing method according to claim 1 or 2, wherein the pulse width te is a second half width corresponding to half of the reference value in the pulse waveform.

5. A laser processing device, which is a laser processing device for forming a laser processing region inside a workpiece along a street of the workpiece by irradiating the workpiece with pulsed laser light with a focal point aligned inside the workpiece, the laser processing device comprising a laser light source emitting the pulsed laser light, wherein
a pulse waveform of the pulsed laser light includes:
a first stage waveform in which a power of the pulsed laser light rises to a maximum value at time t0;
a second stage waveform in which the power falls from the maximum value to a reference value lower than the maximum value at time t1 after the first stage waveform;
and
a third stage waveform in which the power is maintained within a predetermined fluctuation range with respect to the reference value without falling below the reference value after the second stage waveform,
the reference value is within a range of 30% to 60% of the maximum value,
the time t0 is within a range of 1% to 20% of a pulse width te of the pulse waveform,
the time t1 is within a range of 3% to 40% of the pulse width te, and
a time tp corresponding to a first half width, which corresponds to half of the maximum value in the pulse waveform, is within a range of 2% to 40% of the pulse width te.

6. A laser light source, which is a laser light source used for a laser processing device configured to form a laser processing region inside a workpiece along a street of the workpiece by irradiating the workpiece with pulsed laser light with a focal point aligned inside the workpiece, and emitting the pulsed laser light, wherein
a pulse waveform of the pulsed laser light includes:
a first stage waveform in which a power of the pulsed laser light rises to a maximum value at time t0;
a second stage waveform in which the power falls from the maximum value to a reference value lower than the maximum value at time t1 after the first stage waveform;
and
a third stage waveform in which the power is maintained within a predetermined fluctuation range with respect to the reference value without falling below the reference value after the second stage waveform,
the reference value is within a range of 30% to 60% of the maximum value,
the time t0 is within a range of 1% to 20% of a pulse width te of the pulse waveform,
the time t1 is within a range of 3% to 40% of the pulse width te, and
a time tp corresponding to a first half width, which corresponds to half of the maximum value in the pulse waveform, is within a range of 2% to 40% of the pulse width te.
